# FASCICULE DE BREVET EUROPEEN

(11) **EP 1 109 026 B1**
(45) Date de publication et mention de la délivrance du brevet: **10.01.2007**
(21) Numéro de dépôt: 00403337.9
(22) Date de dépôt: 29.11.2000
(51) Int. Cl.: G01R 19/165, G11C 16/12, G11C 5/14, G05F 1/571

(54) **Dispositif de détection d'une haute tension**
Vorrichtung zur Detektion einer Hochspannung
Apparatus for detecting a high voltage

(30) Priorité: 30.11.1999 FR 9915113
(43) Date de publication de la demande: 20.06.2001
(73) Titulaire: STMicroelectronics S.A., 92120 Montrouge (FR)
(72) Inventeur: Fournel, Richard, 94230 Cachan (FR)
(74) Mandataire: Ballot, Paul Denis Jacques

(56) Documents cités:
- EP-A- 0 626 581
- EP-A- 0 788 231
- EP-A- 0 798 565
- US-A- 5 644 215

## Description

La présente invention concerne un dispositif de détection d'une haute tension. Elle s'applique notamment aux circuits intégrés comprenant des éléments de mémoire non volatile électriquement programmable.

La programmation de ces éléments mémoire nécessite de manière bien connue, l'utilisation d'une haute tension. Par exemple, pour un circuit intégré alimenté sous 2,5 volts, cette haute tension atteint environ 8 volts. Dans certains circuits, cette haute tension est générée en interne, au moyen d'une pompe de charges.

Dans d'autres circuits, cette haute tension est appliquée sur une broche externe du circuit intégré. Dans ce cas, la spécification client du circuit intégré donne des indications sur les caractéristiques que doit avoir cette haute tension : valeur nominale, plage de valeur autour de la valeur nominale, et fenêtre temporelle d'application de cette haute tension avant utilisation interne. Par exemple, la spécification client indiquera que la haute tension a une valeur nominale de 8 volts dans une plage de 7,5 à 9 volts, et doit être appliquée dans une fenêtre temporelle de 500 nanosecondes à 1 milliseconde avant son utilisation effective en interne. L'utilisateur qui veut par exemple effectuer un accès en écriture d'un élément mémoire, doit ainsi respecter une certaine séquence temporelle pour envoyer sa commande d'écriture avec l'adresse et la donnée à écrire et pour appliquer la haute tension.

En pratique, vu du circuit intégré, on a donc une fenêtre temporelle d'application externe de la haute tension. On sait que la haute tension est appliquée dans cette fenêtre, mais on ne sait pas à quel moment. En outre, on ne sait pas avec quelle pente est appliquée cette haute tension. Si la pente de montée en tension est très rapide, la haute tension est appliquée de façon trop brutale sur les transistors MOS du circuit, entraînant des risques de claquage de ces transistors. Si elle est trop lente, on risque d'utiliser la haute tension en dehors de la plage de valeur spécifiée, entraînant une perte d'information (mauvaise écriture).

Ainsi, un objet de l'invention est de détecter l'application de la haute tension sur le circuit intégré, pour permettre une utilisation de cette haute tension de façon optimale pour le circuit intégré. Dans l'état de la technique, le document EP 0 768 231 décrit un dispositif de détection de la haute tension comprenant un 1^{er} étage à diodes connecté entre la haute tension et la masse, qui fournit un signal appliqué à un inverseur (pour la détection d'un seuil), alimenté entre la tension d'alimentation logique et la masse. Une utilisation optimale du circuit intégré peut comprendre notamment la régénération d'une rampe de haute tension adaptée ou le contrôle de l'application de cette haute tension à des circuits avec une valeur optimale. Dans ce contexte, l'invention peut aussi bien s'appliquer dans le cas où la haute tension est générée en interne, la détection de l'application sur un noeud interne permettant de générer des signaux de séquencement en fonction du niveau effectif atteint par la haute tension, ce qui permet de rendre le séquencement indépendant de paramètres influant sur le fonctionnement de la pompe de charges.

Un autre objet de l'invention est de détecter la présence de la haute tension de manière à mettre en marche les générateurs de tension de référence, permettant de cette façon de diminuer le stress sur les transistors MOS.

Une solution à ces différents problèmes techniques a été trouvée dans un dispositif de détection de haute tension apte à détecter le dépassement d'un seuil sur un signal fourni par un diviseur de la haute tension, comprenant un circuit de détection à seuil connecté entre la tension d'alimentation logique et la masse. Il comprend en outre une boucle de contre-réaction pour limiter la tension en sortie du diviseur, après le dépassement du seuil cette boucle de contre-réaction étant connectée en sortie à un noeud interne du circuit diviseur situé entre le noeud de haute tension et le noeud de sortie du circuit diviseur. Ainsi, le circuit de détection opère dans la gamme de niveaux de tension logique, ce qui permet l'utilisation de transistors standards.

L'invention concerne donc un dispositif de détection de l'application d'une haute tension sur un noeud interne d'un circuit intégré, comprenant un circuit diviseur de la haute tension et un circuit de détection d'un seuil recevant en entrée un signal fourni par un noeud de sortie du circuit diviseur et fournissant en sortie un signal de détection de dépassement du seuil. Selon l'invention le circuit de détection est un circuit connecté entre la tension d'alimentation logique et la masse et le dispositif de détection comprend en outre une boucle de contre-réaction en sortie du circuit diviseur, pour limiter la montée en tension sur le noeud de sortie du circuit diviseur après le dépassement du seuil de détection, cette boucle de contre-réaction étant connectée en sortie à un noeud interne du circuit diviseur situé entre le noeud de haute tension et le noeud de sortie du circuit diviseur.

D'autres caractéristiques et avantages de l'invention sont détaillés dans la description suivante faite à titre indicatif et non limitatif et en référence aux dessins annexés dans lesquels :
- la figure 1 représente un schéma bloc général d'un dispositif selon l'invention ;
- la figure 2 représente un schéma détaillé d'un premier mode de réalisation de l'invention ;
- la figure 3 est un chronogramme de l'évolution en tension des différents signaux dans le dispositif représenté à la figure 2 ;
- la figure 4 est un schéma détaillé d'un deuxième mode de réalisation de l'invention ; et
- la figure 5 est un chronogramme de l'évolution en tension des différents signaux dans le dispositif représenté à la figure 4.

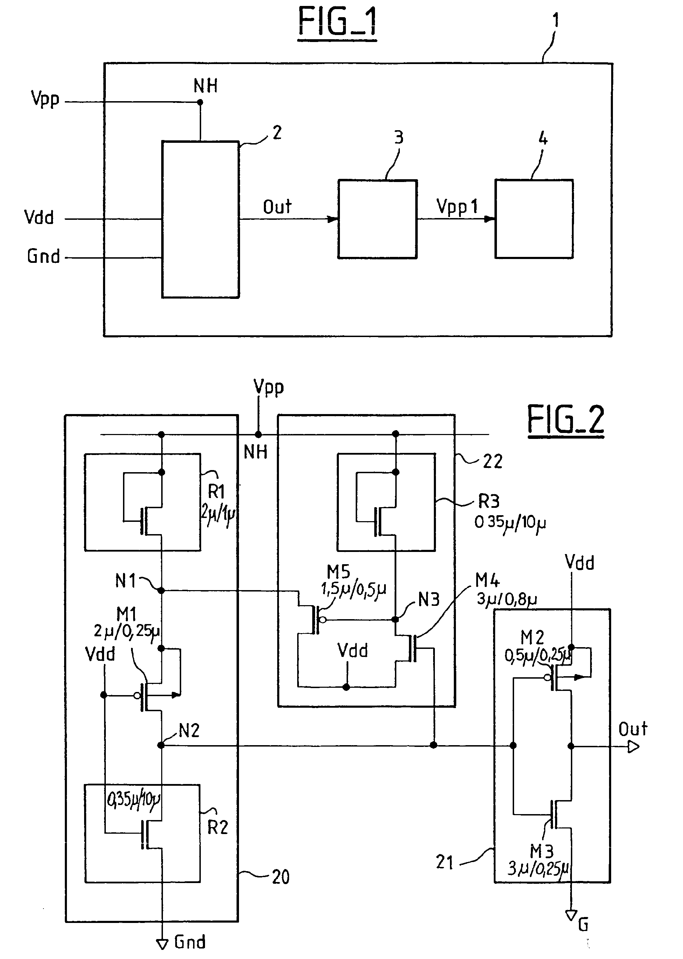

La figure 1 représente un circuit intégré 1 comprenant un dispositif 2 de détection selon l'invention. Ce circuit intégré reçoit notamment sur des broches externes, les tensions d'alimentation logique Vdd et Gnd et une haute tension Vpp.

Ces tensions sont appliquées au dispositif 2 de détection selon l'invention, pour détecter l'application de la haute tension Vpp. Ce dispositif de détection fournit un signal de détection Out. Ce signal de détection est appliqué dans l'exemple à un dispositif de remise en forme et commutation 3, pour fournir en sortie, lorsque le signal de détection Out est activé, une tension de programmation modifiée Vppl vers des circuiteries 4 du circuit intégré. Par exemple, ces circuiteries comprennent des décodeurs associés à une mémoire non volatile, pour programmer ou effacer des cellules de cette mémoire.

Le dispositif de détection selon l'invention a pour fonction de détecter le dépassement d'un seuil de tension du signal Vpp, indiquant la montée en tension sur un noeud interne de haute tension NH, correspondant à l'application de la haute tension Vpp sur une broche externe du circuit intégré ou par un dispositif à pompe de charges interne.

On notera que, dans le cas où la tension est appliquée sur une broche externe, comme représenté sur la figure 1, un circuit de protection contre les décharges électrostatiques (non représenté) est généralement prévu, connecté à proximité de cette broche, entre la broche et le noeud de haute tension NH.

Selon l'invention, cette détection n'utilise pas de tension de référence basée sur cette haute tension, mais un diviseur de la haute tension pour fournir un signal évoluant dans la gamme de niveaux de tension logique à un circuit de détection d'un seuil, typiquement un inverseur. De cette façon, le circuit de détection est réalisé au moyen de transistors standards. Pour cela le dispositif est complété d'une boucle de contre-réaction, déclenchée par le dépassement du seuil en sortie du diviseur, pour limiter la montée en tension sur cette sortie.

Un premier mode de réalisation d'un dispositif de détection selon l'invention est représenté sur la figure 2, en technologie CMOS. L'invention ne se limite pas à une réalisation dans cette technologie.

Le dispositif de détection représenté sur la figure 2 comprend un circuit diviseur de la haute tension Vpp 20 connecté entre un noeud de haute tension NH et la masse Gnd. Un noeud de sortie N2 de ce diviseur fournit un signal appliqué à un circuit de détection à seuil 21. Ce circuit de détection est dans l'exemple un inverseur. L'invention ne se limite pas à cet exemple de réalisation du circuit de détection à seuil, qui pourrait être basé, dans un autre exemple non représenté, sur un circuit de type band-gap.

Le signal fourni par le noeud de sortie N2 du circuit diviseur est appliqué en entrée d'une boucle de contre-réaction 22, pour limiter la montée en tension sur le noeud de sortie N2, après le dépassement du seuil de détection.

Le circuit diviseur comprend une première résistance R1, connectée entre le noeud de haute tension NH et un premier noeud interne N1, un transistor M1 connecté entre le noeud interne N1 et le noeud de sortie N2 et dont la grille est polarisée par la tension d'alimentation logique Vdd, et une deuxième résistance R2 connectée entre le noeud de sortie N2 et la masse Gnd.

Dans l'exemple, le transistor M1 est un transistor MOS de type P. La première résistance R1 et la deuxième résistance R2 sont des éléments résistifs aptes à supporter la haute tension. Selon les applications et la technologie considérée, elles seront réalisées en polysilicium, par des caissons N, ou encore par des transistors MOS N ou P. Dans l'exemple, ces résistances R1 et R2 sont chacunes réalisées par un transistor MOS de type N. Le transistor formant la première résistance R1 a ainsi son drain et sa grille connectés en commun au noeud de haute tension et sa source connectée à la source du transistor M1. Ce transistor doit être apte à supporter la haute tension.

Le transistor formant la deuxième résistance R2 a son drain connecté au drain du transistor M1 et sa source connectée à la masse. Sa grille est commandée par la tension d'alimentation logique Vdd. Ce transistor doit être apte à supporter la haute tension imposée entre son drain et sa source par le noeud de sortie N2.

Le transistor M1 a sa grille commandée par la tension d'alimentation logique Vdd. Sa prise de caisson (bulk) est de préférence connectée a sa source.

Le circuit de détection 21 comprend dans l'exemple un inverseur de type CMOS. Cet inverseur comprend ainsi de manière bien connue, un transistor MOS de type P M2 et un transistor MOS de type N M3 connectés en série entre la tension d'alimentation logique Vdd et la masse, les grilles de ces transistors étant connectées en commun, et au noeud de sortie N2 de l'étage d'entrée, leurs sources connectées en commun fournissant le signal de détection Out du dispositif de détection selon l'invention.

Le noeud interne N1 du circuit diviseur, entre la première résistance R1 et le transistor M1, est commandé par la sortie de la boucle de contre-réaction 22, lorsque cette dernière est activée.

Cette boucle de contre-réaction comprend une résistance R3 connectée entre le noeud de haute tension NH et un noeud interne N3, un premier transistor M4 connecté entre ce noeud interne N3 et la tension d'alimentation logique Vdd, et un deuxième transistor M5 connecté entre le noeud N1 du circuit diviseur et la tension d'alimentation logique Vdd. Le premier transistor M4 est dans l'exemple un transistor Mos de type N dont la grille est commandée par le signal fourni par le noeud de sortie N2 du circuit diviseur. Le deuxième transistor M5 est dans l'exemple un transistor Mos de type P, dont la grille est connectée par le noeud interne N3 de la boucle. La prise de caisson de ce transistor P est connectée, avec la source, au noeud interne N1 du circuit diviseur.

De même que les résistances R1 et R2, la résistance R3 est un élément apte à supporter la haute tension, qui peut être réalisé en polysilicium, par un caisson N, ou encore par un transistor MOS N ou P.

Dans l'exemple, la résistance R3 est réalisée par un transistor MOS de type N, dont la grille est connectée au drain.

On notera que dans l'exemple, les résistances sont des transistors Mos de type N. Ce pourrait tout aussi bien être des transistors Mos de type P haute tension.

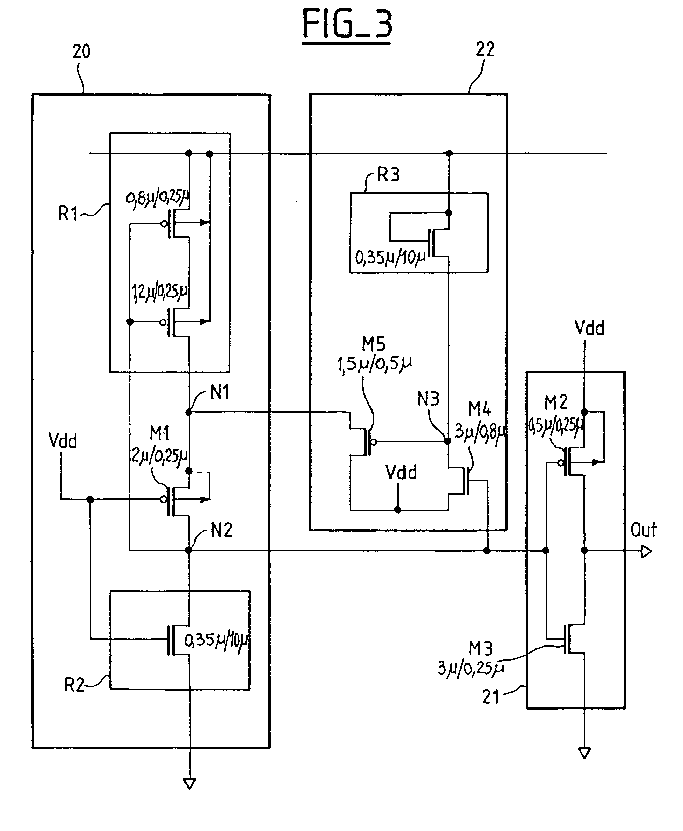

Le fonctionnement d'un tel dispositif va maintenant être expliqué, en relation avec le chronogramme représenté sur la figure 3, qui montre l'évolution de différents de la tension en différents points du dispositif avec la montée de la haute tension Vpp.

On a ainsi plus particulièrement représenté les tensions V1 et V2 aux noeuds N1 et N2 du circuit diviseur ; la tension Vout en sortie Out du dispositif ; et la tension V3 au noeud N3 de la boucle de contre-réaction.

Le fonctionnement est ainsi le suivant.

Au départ, quand la haute tension Vpp n'est pas appliquée sur le noeud de haute tension. Le noeud de sortie N2 est maintenu à la masse par la résistance R2. Le noeud N3 est aussi à la masse. Comme ce noeud N3 commande la grille du transistor M5, qui est un transitor PMOS, ce dernier tire donc le noeud N1 à Vdd.

On applique la haute tension sur le noeud de haute tension NH. La tension monte sur ce noeud de haute tension NH. Le noeud interne N1 du circuit diviseur suit cette montée en tension. Dès que la tension au noeud interne N1 devient supérieure à la tension d'alimentation logique Vdd augmentée de la tension de seuil du transistor M1, se dernier se met à conduire. Le noeud de sortie N2 (drain du transistor M1) se met alors à suivre la montée en tension du noeud interne N1 (source du transistor M1). Si la tension V2 sur ce noeud de sortie N2 dépasse la tension d'alimentation logique Vdd augmentée de la tension de seuil du transistor M4 de la boucle de contre-réaction 22, ce transistor M4 se met à conduire, tirant le noeud interne N3 (son drain) à Vdd (tension de source). Ceci met en conduction le deuxième transistor M5 de la boucle de contre-réaction. Ce transistor M5, moins résistif que la résistance R1, limite la montée en tension sur le noeud N1, et par suite, sur le noeud N2.

C'est le dimensionnement de la résistance R1 par rapport au transistor M5 qui détermine la tension limite sur le noeud N1 et par suite la tension limite sur le noeud N2. Ce dimensionnement est tel que la tension sur le noeud N2 atteint comme valeur haute maximale, une tension acceptable par de la circuiterie logique, permettant l'utilisation d'un circuit de détection standard. En d'autres termes, la tension au noeud de sortie reste dans une gamme de niveaux de tension logique acceptable par le circuit de détection, en l'occurrence, par les grilles des transistors MOS. Dans l'exemple, pour une haute tension Vpp de valeur nominale 8 volts, cette valeur maximale de tension sur le noeud N2 est de l'ordre de 5 volts. Ce niveau est ajusté en fonction de l'application et de la structure interne du circuit de détection à seuil.

Dans le cas de figure correspondant au chronogramme de la figure 3, le circuit de détection est dimensionné pour basculer au passage d'un seuil de l'ordre de 4,5 volts. La sortie Out de l'inverseur passe de 1 à 0 dans l'exemple. Ce passage à 0 déclenche par exemple un dispositif 3 de remise en forme du signal de haute tension (figure 1).

Sur la figure 3, on a aussi représenté la tension au noeud interne N3 de la boucle de contre-réaction : Ce noeud interne N3 suit d'abord la montée en tension de Vpp (résistance R3). La mise en conduction du transistor M4 met fin à cette montée en tension et ramène ce noeud à Vdd. Le transistor M4 doit être dimensionné de manière appropriée par rapport à la résistance R3 pour pouvoir tirer le noeud interne N3 à Vdd.

Comme très clairement représenté sur cette figure, le déclenchement de la boucle de contre-réaction n'intervient qu'après le dépassement du seuil sur le noeud de sortie N2, c'est à dire après la détection par le circuit de détection : basculement de 0 à 1 du signal Out car le transistor M4 déclenche à Vdd + VtN et le seuil du circuit de détection est forcément compris entre 0 et Vdd.

Le dispositif de détection selon l'invention nécessite l'utilisation de très peu d'éléments haute tension : les seuls éléments concernés sont les résistances du dispositif qui dans l'exemple sont formées par des transistors MOS N. Ainsi, le transistor de chacune des résistances R1 et R3 doit tenir la haute tension Vpp entre drain et source et grille et source. En pratique, dans l'exemple, la résistance R1 doit tenir entre Vpp et N1, soit 3 volts maximum et la résistance R2 entre Vpp et N3 soit 5,5 volts maximum pour Vpp à 8 volts. Le transistor réalisant la résistance R2 doit tenir la tension entre drain et source, donnée par l'amplitude maximum sur N2, soit 5 volts dans l'exemple, pour une tension d'alimentation Vdd de 2,5 volts. Pour ces transistors du type haute tension, on utilise tout type disponible connu de l'homme du métier apte à supporter la haute tension indiquée.

Les transistors M1, M4 et M5 et les transistors de l'étage de détection sont eux des transistors standards.

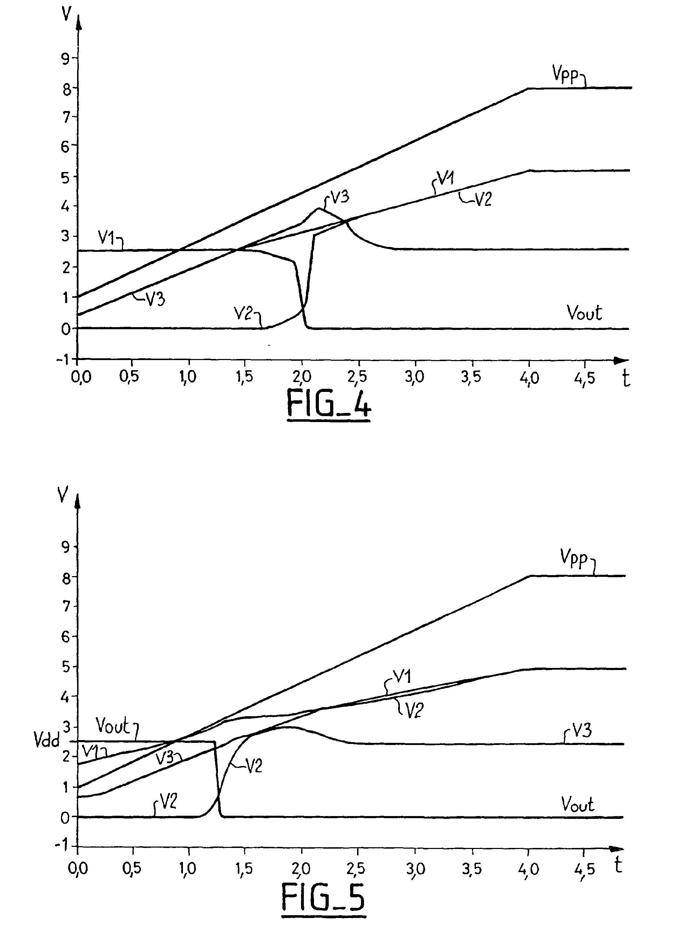

La figure 4 représente un deuxième mode de réalisation d'un dispositif de détection selon l'invention. Il diffère du premier dans l'utilisation d'au moins deux transistors standards contrôlés par le noeud de sortie N2 pour réaliser la résistance R1, pour ne pas avoir à utiliser un transistor tenant la haute tension. Dans l'exemple, cette résistance R1 est ainsi réalisée au moyen de deux transistors MOS de type P en série, dont les grilles sont connectées au noeud de sortie N2. La prise de caisson de chacun de ces transistors est reliée au noeud de haute tension NH.

Cette variante de réalisation de la résistance R1 peut être appliquée à la résistance R3 (variante non représentée). Cette résistance R3 serait alors formée par deux transistors PMOS standards en série dont les grilles seraient connectées au noeud de sortie N2.

Le chronogramme correspondant est représenté sur la figure 5. Les autres éléments du dispositif de détection étant tous identiques, il montre une montée en tension avec la haute tension Vpp plus rapide sur le noeud de sortie N2, permettant une détection plus rapide. Par contre, la mise en route de la boucle de contre-réaction après la détection est moins rapide. Ceci est dû à la connection de grille des transistors PMOS de la résistance R1 au noeud de sortie N2, qui fait que les deux transistors PMOS ne fonctionnent plus totalement en résistance. En connectant les grilles des transistors PMOS de la résistance R1 au noeud N1, on retrouverait un fonctionnement plus proche de celui du dispositif à transistors MOS N (remarque applicable le cas échéant à la résistance R3).

## Revendications

1. Dispositif de détection de l'application d'une haute tension (Vpp) sur un noeud interne (NH) d'un circuit intégré, comprenant un circuit diviseur de la haute tension (20) et un circuit de détection d'un seuil (21), connecté entre la tension d'alimentation logique (Vdd) et la masse (Gnd), recevant en entrée un signal fourni par un noeud de sortie (N2) du circuit diviseur et fournissant en sortie un signal (Out) de détection de dépassement du seuil, le dispositif de détection comprenant en outre une boucle de contre-réaction (22) en sortie du circuit diviseur (20), pour limiter la montée en tension sur le noeud de sortie (N2) du circuit diviseur après le dépassement du seuil de détection à une valeur haute maximale comprise dans une gamme de niveaux de tension logique acceptable par le circuit de détection,
**caractérisé en ce que** ladite boucle de contre-réaction (22) est connectée en sortie à un noeud interne (N1) du circuit diviseur (20) situé entre le noeud de haute tension (NH) et le noeud de sortie (N2) du circuit diviseur.

2. Dispositif de détection selon la revendication 1, **caractérisé en ce que** le circuit diviseur (20) comprend une première résistance (R1) connectée entre le noeud de haute tension (NH) et ledit noeud interne (N1), un transistor (M1), connecté entre ledit noeud interne (N1) et le noeud de sortie (N2) et dont la grille reçoit la tension d'alimentation logique (Vdd) et une deuxième résistance (R2), connectée entre le noeud de sortie (N2) et la masse (Gnd).

3. Dispositif de détection selon la revendication 2, **caractérisé en ce que** la première résistance (R1) et la deuxième résistance (R2) sont des éléments aptes à supporter la haute tension.

4. Dispositif selon la revendication 3, **caractérisé en ce que** la première résistance (R1) est formée par au moins deux transistors MOS standard en série ayant leurs grilles connectées au noeud de sortie (N2) ou au noeud interne (N1) du circuit diviseur (20).

5. Dispositif selon l'une quelconque des revendications précédentes, **caractérisé en ce que** la boucle de contre-réaction (225) comprend une résistance (R3) connectée entre le noeud de haute tension (NH) et un noeud interne (N3), un premier transistor (M4) connecté entre ce noeud interne (N3) et la tension d'alimentation logique (Vdd) dont la grille est connectée au noeud de sortie (N2) du circuit diviseur (20), et un deuxième transistor (M5) connecté entre le noeud interne (N1) du circuit diviseur et la tension d'alimentation logique (Vdd) et dont la grille est connectée au noeud interne (N3) de la boucle.

6. Dispositif de détection selon la revendication précédente, **caractérisé en ce que** la résistance (R3) de la boucle (22) est du type apte à supporter la haute tension.

7. Dispositif de détection selon la revendication 6, **caractérisé en ce que** la résistance (R3) de la boucle est formée par au moins deux transistors MOS standard en série ayant leurs grilles connectées au noeud de sortie (N2) ou au noeud interne (N1) du circuit diviseur (20).

8. Dispositif de détection selon l'une quelconque des revendications précédentes, **caractérisé en ce que** le circuit de détection (21) comprend un inverseur (M2, M3) .

9. Dispositif de détection selon l'une quelconque des revendications précédentes, **caractérisé en ce qu'**il est réalisé en technologie MOS ou CMOS.

## Claims

1. A device for detecting the application of a high voltage (Vpp) to an internal node (NH) of an integrated circuit comprising a high-voltage divider circuit (20) and a threshold detection circuit (21) receiving a signal at input given by an output node (N2) of the divider circuit and giving a threshold crossing detection signal (Out) at output, wherein said detection circuit is a circuit connected between the logic supply voltage (Vdd) and the ground (Gnd), the detection device furthermore comprising a negative feedback loop (22) at output of the divider circuit (20) to limit the voltage build-up at the output node (N2) of the divider circuit after the crossing of the detection threshold at a maximum high value comprised within a range of logic voltage levels acceptable by the detection circuit, wherein said negative feedback loop (22) is connected at output to an internal node (N1) of the divider circuit (20) located between the high-voltage node (NH) and the output node (N2) of the divider circuit.

2. A detection device according to claim 1, wherein the divider circuit (20) comprises a first resistor (R1) connected between the high-voltage node (NH) and said internal node (N1), a transistor (M1) connected between said internal node (N1) and the output node (N2) with its gate receiving the logic supply voltage (Vdd) and a second resistor (R2) connected between the output node (N2) and the ground (GND).

3. A detection device according to claim 2, wherein the first resistor (R1) and the second resistor (R2) are elements capable of withstanding the high voltage.

4. A device according to claim 1, wherein the first resistor (R1) is formed by at least two standard MOS transistors in series having their gates connected to the output node (N2) or to the internal node (N1) of the divider circuit (20).

5. A device according to any of the above claims, wherein the negative feedback loop (22) comprises a resistor (R3) connected between the high-voltage node (NH) and an internal node (N3), a first transistor (M4) connected between this internal node (N3) and the logic supply voltage (Vdd), with its gate connected to the output node (N2) of the divider circuit (20), and a second transistor (M5), connected between the internal node (N1) of the divider circuit and the logic supply voltage (Vdd), with its gate connected to the internal node (N3) of the loop.

6. A detection device according to the previous claim, wherein the resistor (R3) of the loop (22) is of the type capable of withstanding the high voltage.

7. A detection device according to claim 6, wherein the resistor (R3) of the loop is formed by at least two series-connected standard MOS transistors having their gates connected to the output node (N2) or to the internal node (N1) of the divider circuit (20).

8. A detection device according to any of the previous claims, wherein the detection circuit (21) comprises an inverter (M2, M3).

9. A detection device according to any of the previous claims, made with MOS or CMOS technology.

## Patentansprüche

1. Vorrichtung zur Erfassung des Anliegens einer hohen Spannung (Vpp) an einem internen Knoten (NH) einer integrierten Schaltung, mit einer Hochspannungs-Teilerschaltung (20) und einer Schwellenwert-Erfassungsschaltung (21), die zwischen der Logik-Versorgungsspannung (Vdd) und der Masse (Gnd) geschaltet ist und am Eingang ein von einem Ausgangsknoten (N2) der Teilerschaltung geliefertes Signal erhält und am Ausgang ein Signal (OUT) zur Erfassung eines Überschreitens des Schwellenwertes liefert, wobei die Erfassungsvorrichtung ferner eine Gegenreaktion-Schleife (22) am Ausgang der Teilerschaltung (20) aufweist, um den Anstieg der Spannung am Ausgangsknoten (N2) der Teilerschaltung nach dem Überschreiten der Erfassungsschwelle auf einen maximalen Höchstwert zu begrenzen, der in einem Bereich von für die Erfassungsschaltung akzeptablen Logik-Spannungsniveaus enthalten ist, **dadurch gekennzeichnet, dass** die Gegenreaktion-Schleife (22) am Ausgang an einen internen Knoten (N1) der Teilerschaltung (20) angeschlossen ist, der zwischen dem Hochspannungsknoten (NH) und dem Ausgangsknoten (N2) der Teilerschaltung liegt.

2. Erfassungsvorrichtung nach Anspruch 1, **dadurch gekennzeichnet, dass** die Teilerschaltung (20) aufweist einen ersten Widerstand (R1), der zwischen den Hochspannungsknoten (NH) und den internen Knoten (N1) geschaltet ist, einen Transistor (M1), der zwischen den internen Knoten (N1) und den Ausgangsknoten (N2) geschaltet ist und dessen Gate die Logik-Versorgungsspannung (Vdd) erhält, und einen zweiten Widerstand (R2), der zwischen die Ausgangsknoten (N2) und die Masse (Gnd) geschaltet ist.

3. Erfassungsvorrichtung nach Anspruch 2, **dadurch gekennzeichnet, dass** der erste Widerstand (R1) und der zweite Widerstand (R2) Elemente sind, welche die Hochspannung aushalten können.

4. Vorrichtung nach Anspruch 3, **dadurch gekennzeichnet, dass** der erste Widerstand (R1) durch wenigstens zwei Transistoren im Reihen-MOS-Standard gebildet ist, deren Gates an den Ausgangsknoten (N2) oder an den internen Knoten (N1) der Teilerschaltung (20) angeschlossen sind.

5. Vorrichtung nach einem der vorstehenden Ansprüche, **dadurch gekennzeichnet, dass** die Gegenreaktion-Schleife (225) aufweist einen Widerstand (R3), der zwischen dien Hochspannungsknoten (NH) und die internen Knoten (N3) geschaltet ist, einen ersten Transistor (N4), der zwischen diese internen Knoten (N3) und die Logik-Versorgungsspannung (Vdd) geschaltet ist, deren Gate an den Ausgangsknoten (N2) der Teilerschaltung (20) angeschlossen ist, und einen zweiten Transistor (M5), der zwischen die internen Knoten (N1) der Teilerschaltung und die Logik-Versorgungsspannung (Vdd) geschaltet ist und dessen Gate an den internen Knoten (N3) der Schleife angeschlossen ist.

6. Erfassungsvorrichtung nach dem vorhergehenden Anspruch, **dadurch gekennzeichnet, dass** der Widerstand (R3) der Schleife (22) derart ausgebildet ist, dass dieser die Hochspannung aushält.

7. Erfassungsvorrichtung nach Anspruch 6, **dadurch gekennzeichnet, dass** der Widerstand (R3) der Schleife durch wenigstens zwei Transistoren im Reihen-MOS-Standard gebildet ist, die mit ihren Gates an den Ausgangsknoten (N2) oder den internen Knoten (N1) der Teilerschaltung (20) angeschlossen sind.

8. Erfassungsvorrichtung nach einem der vorstehenden Ansprüche, **dadurch gekennzeichnet, dass** die Erfassungsschaltung (21) einen Umschalter (M2, M3) umfasst.

9. Erfassungsvorrichtung nach einem der vorstehenden Ansprüche, **dadurch gekennzeichnet, dass** diese in MOS- oder CMOS-Technologie ausgeführt ist.
